# EUROPEAN PATENT SPECIFICATION

(11) **EP 3 754 848 B1**
(45) Date of publication and mention of the grant of the patent: **15.11.2023**
(21) Application number: 19305792.4
(22) Date of filing: 20.06.2019
(51) Int. Cl.: H03K 17/16, G05F 1/46, H04B 5/00, G05F 1/565

(54) **NEAR FIELD COMMUNICATIONS IC AND METHOD FOR MOBILE COMMUNICATIONS DEVICE**
NAHFELDKOMMUNIKATIONS-IC UND VERFAHREN FÜR EINE MOBILKOMMUNIKATIONSVORRICHTUNG
CI DE COMMUNICATION EN CHAMP PROCHE ET PROCÉDÉ POUR DISPOSITIF DE COMMUNICATION MOBILE

(43) Date of publication of application: 23.12.2020
(73) Proprietor: NXP B.V., 5656 AG Eindhoven (NL)
(72) Inventor: BOITARD, Fabien, 31023 Toulouse cedex 1 (FR); ODDOART, Ludovic, 31023 Toulouse cedex 1 (FR)
(74) Representative: Hardingham, Christopher Mark

(56) References cited:
- EP-A1- 2 738 671
- EP-A1- 3 258 611
- EP-A2- 2 450 835
- US-A1- 2013 169 059
- SEYED JAVAD AZHARI ET AL: "A novel ultra-high compliance, high output impedance low power very accurate high performance current mirror", MICROELECTRONICS JOURNAL, MACKINTOSH PUBLICATIONS LTD. LUTON, GB, vol. 42, no. 2, 11 October 2010 (2010-10-11), pages 432-439, XP028132592, ISSN: 0026-2692, DOI: 10.1016/J.MEJO.2010.10.004 [retrieved on 2010-10-14]

## Description

### BACKGROUND

The present specification relates to a near field communications (NFC) integrated circuit for a mobile communications device. The present specification also relates to a mobile communications device including the near field communications (NFC) integrated circuit. The present specification further relates to a method of operating a mobile communications device.

In an OFF state of a mobile communications device such as a mobile phone, the Universal Integrated Circuit Card (UICC) is not directly supplied by the mobile communications device platform. A Near Field Communications (NFC) chip of the mobile communications device may therefore need to use an internal regulator to supply the UICC in order to perform secure transactions.

In order to reduce current consumption, a simple switch may be used to supply the external UICC from an internal regulator, such as a central supply of the NFC chip. This solution may generally only be used when the mobile communications device is in its OFF state, in which case the external UICC does not get any supply from phone platform. The switch may be low ohmic in order to provide a supply that is compliant with the ETSI standard (1.62V @ 10ma).

United States patent application publication number US 2013/0169059 A1 discloses systems, methods and platforms for power multiplexer switching operations. The system may include a new field communication module configured to receive power through a radio frequency channel; a subscriber identity module circuit configured with a supply voltage port; and a power multiplexer circuit configured to controllably couple the SIM circuit supply voltage port to the NFC module, wherein the NFC module provides a supply voltage to the SIM circuit such that the SIM circuit is operable in the absence of primary device power source.

### SUMMARY

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided a near field communications (NFC) integrated circuit for a mobile communications device, the integrated circuit comprising:
a power supply rail for providing a regulated supply of power to components within the integrated circuit;
a first transistor coupled between the power supply rail and a power supply output of the integrated circuit for selectively providing power to a universal integrated circuit card (UICC) of the mobile communications device from the power supply rail while the mobile communications device is in an off state; and
a current control circuit for controlling the operation of the first transistor to prevent a drop in voltage on the power supply rail as the first transistor is switched to an on state to couple the power supply rail to the power supply output.

The provision of the current control circuit can protect components of the near field communications integrated circuit against a current peak that may be drawn to load an external capacitance on the universal integrated circuit card supply, leading to a drop in voltage on the power supply rail as the first transistor is switched to an on state to couple the power supply rail to the power supply output. This drop in voltage may otherwise cause a reset of the near field communications integrated circuit, or other functionality problems relating to the operation of the internal components of the near field communications integrated circuit, which are also supplied from the power supply rail.

In the embodiment of the claimed invention, the current control circuit includes a first switch; a second switch, wherein a gate of the first transistor is coupleable to reference potential via the second switch; a second transistor having a gate coupleable to the gate of the first transistor via the first switch, and a third transistor and a fourth transistor, wherein a gate of the third transistor is coupled to a gate of the fourth transistor. The second transistor and the fourth transistor may be coupled in series between the power supply rail and a first current source. The first transistor and the third transistor may be coupled in series between the power supply rail and a second current source. A node located between the fourth transistor and the first current source may be coupled to a node located between the gate of the second transistor and the first switch. A node located between the third transistor and the second current source may be coupled to the gates of the third transistor and fourth transistor.

The current control circuit may be operable in an initial step for switching the first transistor to the on state to close the first switch and to open the second switch. In this way, current flow from the power supply rail to the power supply output may be governed by a ratio of currents flowing through the first transistor and the second transistor. This can allow current to be drawn to load the external capacitance on the universal integrated circuit card supply without leading to a drop in voltage on the power supply rail in the initial step.

The current control circuit may be operable in a next step for switching the first transistor to the on state to open the first switch and to close the second switch. The first transistor may thus be fully switched to its on state to provide power from the power supply rail to the power supply output. As the voltage at the power supply output rises, the first transistor may subsequently (i.e. in the next step) be fully switched on (by operating the first and second switches using the control signals) without leading to the aforementioned drop in voltage on the power supply rail.

In one embodiment, the current control circuit may further include a fifth transistor coupled in series with the first transistor and a third current source. The fifth transistor may have a gate coupled to a node located between the first switch and the gate of the first transistor. The fifth transistor may also have a first current terminal coupled to a node located between the first transistor and the power supply output. The fifth transistor may further have a second current terminal coupled to said third current source. The current control circuit may be operable to produce control signals for operating the first switch and the second switch dependent upon a current at the second current terminal. The fifth transistor may thus be used to determine the appropriate time at which the first transistor may be fully switched on without leading to the aforementioned drop in voltage on the power supply rail. For instance, this may be done by determining whether the current at the second current terminal of the fifth transistor exceeds a reference current provided by the third current source.

In one embodiment, the current control circuit may further include a sixth transistor and a seventh transistor forming a current mirror. An input of the current mirror may be coupled to a node located between the second current terminal of the firth transistor and the third current source. The current control circuit may be operable to use an output of the current mirror to produce the control signals. The input of the current mirror may for instance receive a current determined by the difference between the current at the second current terminal of the firth transistor and the reference current provided by the third current source. This can allow the current mirror to determine when the current at the second current terminal of the firth transistor exceeds the reference current provided by the third current source, for generating the appropriate control signals for the first and second switches.

In one embodiment, the current control circuit may further include a latch. The latch may have an input coupled to the output of the current mirror. The latch may have an output. The output of the latch may be coupled to the first switch via an inverter, for providing a first the control signal to the second switch. The output of the latch may also be coupled to the second switch for providing a second said control signal to the second switch. The output of the current mirror may thus be used to program the latch, and the output of the latch may be used to produce the control signals for operating the first switch and the second switch.

Some of the transistors of the current control circuit may be matched. Matching the transistors involves providing substantially equally sized transistors so that the same current flows through each transistor when substantially the same voltages are applied to the terminals of the transistors.

For instance the first and fifth transistors may be substantially matched. This can allow the fifth transistor to be used accurately to detect desaturation in the first transistor.

In another embodiment, the first and second transistors may be substantially matched. This can allow the desired load current I_{load} to flow to the power supply output. In particular, this can allow a copy of the reference current I1 to be obtained, in order to limit I_{load} as the first transistor is being switched to its on state.

In a further embodiment, the third and fourth transistors may be substantially matched. This can allow the same drain voltage to be obtained on the first transistor and the second transistor.

According to another aspect of the present disclosure, there is provided a mobile communications device including the near field communications (NFC) integrated circuit of any of claims 1 to 10.

The mobile communications device may, further include the universal integrated circuit card (UICC).

The mobile communications device may be operable to provide power to the universal integrated circuit card without providing power to the universal integrated circuit card from the near field communications (NFC) integrated circuit when the mobile communications device is in an on state.

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows a mobile communications device in accordance with an embodiment of this disclosure;
Figure 2 shows a circuit for a mobile communications device of the kind shown in Figure 1; and
Figures 3 and 4 show a circuit for a mobile communications device of the kind shown in Figure 1, in accordance with an embodiment of this disclosure.

### DETAILED DESCRIPTION

Embodiments of this disclosure are described in the following with reference to the accompanying drawings.

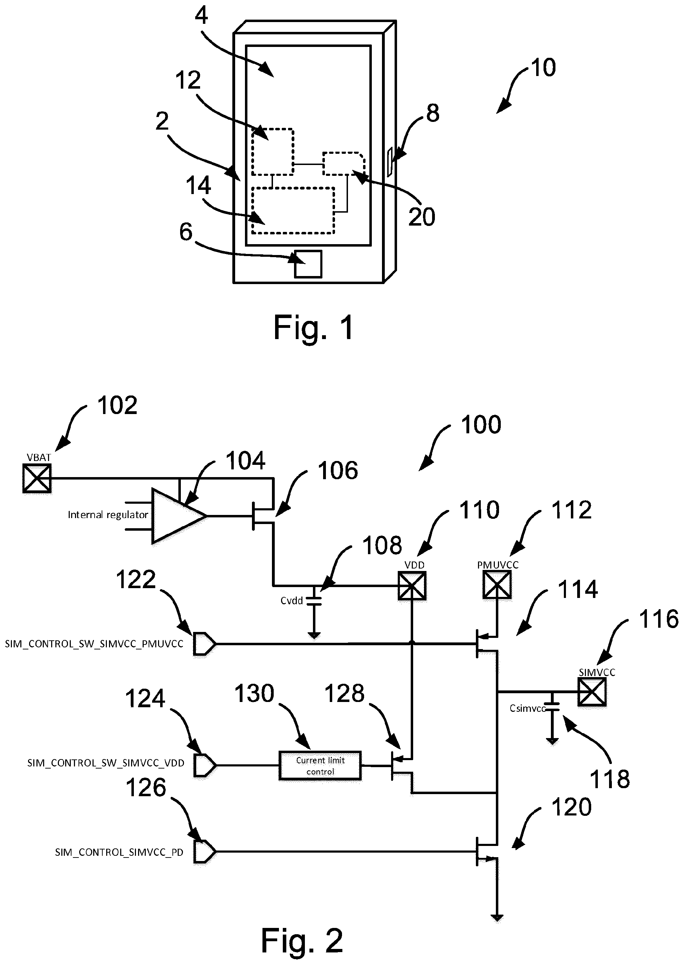

Figure 1 shows a mobile communications device 10 in accordance with an embodiment of this disclosure. The mobile communications device 10 may for instance be a mobile phone, or any other device incorporating a universal integrated circuit card (UICC) and having near field communications (NFC) functionality.

The mobile communications device 10 may include a housing 2, a display 4 and one or more user input devices, such as button(s) 6.

The mobile communications device 10 includes a universal integrated circuit card 20. The housing 2 may include an opening 8, to allow the universal integrated circuit card 20 to be installed.

The housing 2 may contain a battery 12 for powering the mobile communications device 10.

The mobile communications device 10 includes a near field communications (NFC) integrated circuit 14. The near field communications integrated circuit 14 may located inside the housing 2. The near field communications integrated circuit 14 may provide functionality such as secure payment functionality for the mobile communications device 10. This functionality may involve the use of the universal integrated circuit card 20. While the mobile communications device 10 is switched on, the battery 12 may be used to provide power to the universal integrated circuit card 20 via the main internal power supply of the mobile communications device 10. This can allow the mobile communications device 10 to connect with a cellular network, and can also power the universal integrated circuit card 20 during provision of the aforementioned near field communications functionality.

When the mobile communications device 10 is switched off, power cannot be provided directly from the main internal power supply of the mobile communications device 10 to the universal integrated circuit card 20. In accordance with embodiments of this disclosure, to provide near field communications functionality while the mobile communications device 10 is switched off, the near field communications integrated circuit 14 may provide power to the universal integrated circuit card 20, when near field communications functions are required.

Figure 2 shows a circuit 100 for a mobile communications device of the kind shown in Figure 1.

In Figure 2, VBAT 102 represents the power supply received by the near field communications integrated circuit 14. This power supply may be regulated by an internal regulator 104 of the near field communications integrated circuit 14, e.g. using a transistor 106. The regulated power provided by the internal regulator 104 may be provided to a power supply rail 110 (VDD) of the near field communications integrated circuit 14. The power supply rail 110 may be used to provide regulated power to components (e.g. a processor, memory etc.) of the near field communications integrated circuit 14. The power supply rail 110 may have an internal or external capacitance CVDD 108. The power supply rail 110 may, for instance, operate at 1.8V.

SIMVCC 116 represents the power supply to the universal integrated circuit card 20 of the mobile communications device 10. The SIMVCC 116 may, for instance, be a power supply pin for the universal integrated circuit card 20. SIMVCC 116 has an external capacitance CSIMVCC 118.

PMUVCC 112 represents the main internal power supply of the mobile communications device 10 (which may be provided by a power management unit of the mobile communications device 10). When the mobile communications device 10 is switched on, a control signal 122 may be asserted to switch on transistor 114, for providing power to SIMVCC 116 from PMUVCC 122. When the mobile communications device 10 is switched off, the control signal 122 may be de-asserted. Additionally, a control signal 126 may be asserted to switch on transistor 120, to connect SIMVCC 116 to ground, thereby to ensure that no power is provided to SIMVCC 116.

As noted above, when the mobile communications device 10 is switched off, the near field communications integrated circuit 14 may provide power to the universal integrated circuit card 20 - this may be implemented by coupling the power supply rail 110 to SIMVCC 116. When near field communications functionality is required with the mobile communications device 10 switched off, control signal 124 may be asserted for switching on transistor 128, thereby to provide a path from the power supply rail 110 to SIMVCC 116. Control signal 126 may also be de-asserted, to switch off transistor 120, thereby to disconnect SIMVCC 116 from ground.

If transistor 128 were to be fully switched on immediately, this may give rise to the aforementioned current peak that may be drawn to load an external capacitance CSIMCC 118 on the universal integrated circuit card supply. This may in turn lead to a drop in voltage on the power supply rail 110 as the transistor 128 is switched on. This drop in voltage may cause a reset of the near field communications integrated circuit 14, or other functionality problems relating to the operation of the internal components (e.g. a processor, memory etc.) of the near field communications integrated circuit 14, which are also supplied from the power supply rail 110.

The transistor 128 may typically be low ohmic (that is to say that the transistor 128 has a low on state resistance Rₒₙ), so that the power supply provided to the universal integrated circuit card 20 by the near field communications integrated circuit 14 with minimal losses (e.g. to comply with the ETSI standard (1.62V @ 10mA). The low on state resistance Rₒₙ of the transistor 128 may exacerbate the above mentioned problem relating to the current peak that may be drawn to load an external capacitance on the universal integrated circuit card supply.

In order to address this problem, in accordance with embodiments of this disclosure, the near field communications integrated circuit 14 is provided with a current control circuit 130. The current control circuit 130 may operate to manage the switching on of the transistor 128. In particular, the current control circuit 130 may operate to limit the flow of current from the power supply rail 110 to SIMVCC 116, until it is safe to fully turn on the transistor 128 without causing a voltage drop on the power supply rail 110.

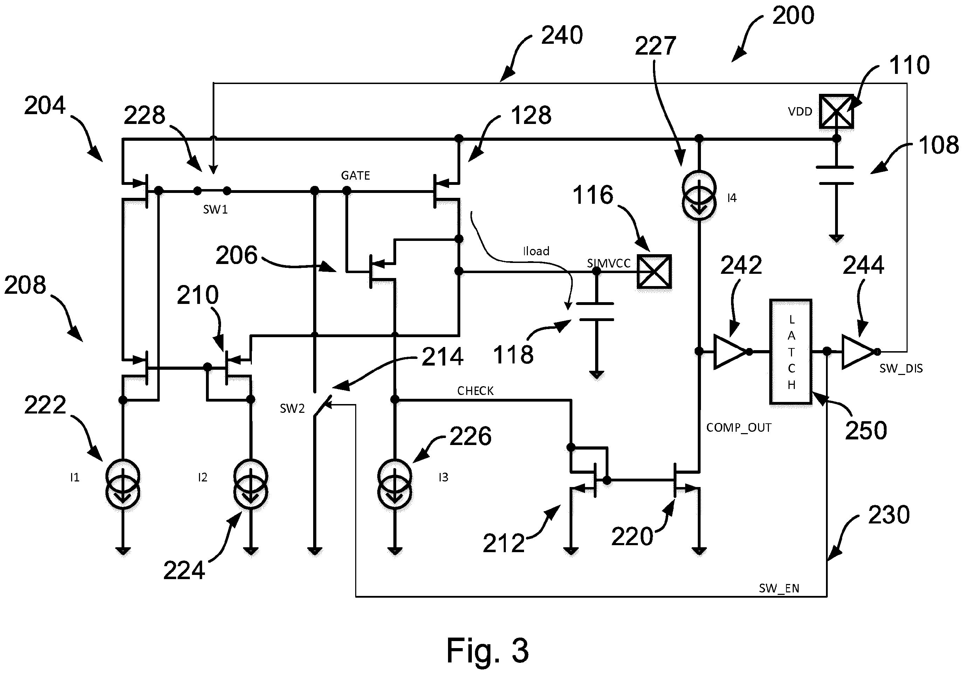

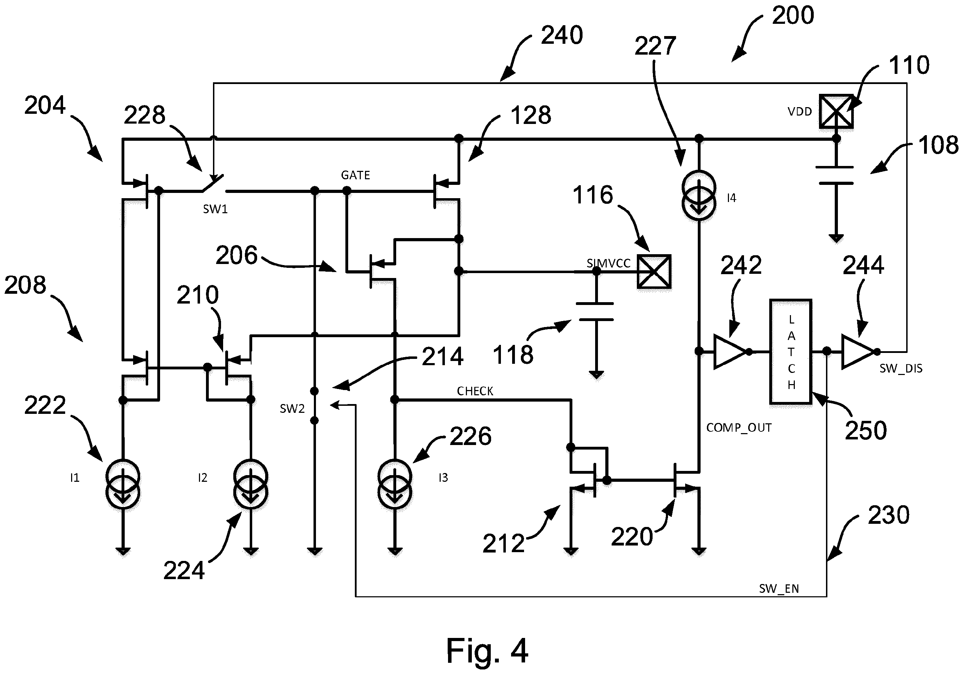

Figures 3 and 4 show a circuit 200 for a mobile communications device of the kind shown in Figure 1, in accordance with an embodiment of this disclosure. The circuit 200 in Figures 3 and 4 incorporates features implementing the current control circuit 130 shown in Figure 2, as well as the transistor 128, the power supply rail 110, and SIMVCC 116.

As will be described below, the circuit 200 includes a first switch 228 and a second switch 214, which are used to implement the current control function as the transistor 128 is being switched on. The switching on of the transistor 128 may comprise two main stages. Figure 3 shows the circuit 200 with the first switch 228 and the second switch 214 configured for the first stage, while Figure 4 shows the circuit 200 with the first switch 228 and the second switch 214 configured for the second stage.

In this embodiment, the circuit 200 includes a first transistor 128, which corresponds to the transistor 128 described above in relation to Figure 2. The circuit 200 also includes a second transistor 204, a third transistor 210 and a fourth transistor 208. The transistors 128, 204, 208, 210 may each be a p-type MOSFET, although this is not essential, and other kinds of transistor may be used instead. Typically, each transistor 128, 204, 208, 210 will be of the same type (i.e. p-type or n-type).

As noted above, the circuit 200 also includes a first switch 228 and a second switch 214. Each switch 228, 214 may be implemented using a transistor.

The connections of the above noted features of the circuit 200 will now be described.

Each transistor 128, 204, 208, 210 may be implemented using a MISFET (e.g. a MOSFET). Any suitable kind of MISFET may be chosen (e.g. enhancement/depletion mode transistors may used). As shown in Figure 3, in this embodiment, a gate of the first transistor 128 is coupleable to reference potential via the second switch 214. When the second switch is closed, the gate of the first transistor 128 is connected to the reference potential, which may be chosen such that the closing of the second switch 214 causes the first transistor 128 to be fully switched on. The reference potential may, for instance be ground.

The second transistor 204 has a gate coupleable to the gate of the first transistor 128 via the first switch 228. Accordingly, the gates of the first transistor 128 and the second transistor 204 may be selectively coupled and decoupled by closing and opening the first switch 228.

The gates of the third transistor 210 and a fourth transistor 208 are coupled together.

The second transistor 204 and the fourth transistor 208 are coupled in series between the power supply rail 110 and a first current source 222. The first transistor 128 and the third transistor 210 are coupled in series between the power supply rail 110 and a second current source 224. Each current source 222, 224 provides a reference current (I1, I2).

A node located between the fourth transistor 208 and the first current source 222 is coupled to a node located between the gate of the second transistor 204 and the first switch 228. A node located between the third transistor 210 and the second current source 224 is coupled to the gates of the third transistor 210 and fourth transistor 208.

In the first stage of switching on the first transistor 128, the first switch 228 is closed and the second switch 214 is open (as shown in Figure 3). In the second stage of switching on the first transistor 128, the first switch 228 is open and the second switch 214 is closed (as shown in Figure 4). The switches 228, 214 are controlled by the current control circuit 130 using control signals. In particular, a first control signal 240 (SW_DIS) is used to open and close the first switch 228 and a second control signal 230 (SW_EN) is used to open and close the second switch 214.

The circuit 200 may be provided with further features for generating the first control signal 240 and the second control signal 230. These will now be described below.

The current control circuit may further comprise a fifth transistor 206. The fifth transistor 206 may be coupled in series with the first transistor 128 and a third current source 226. The third current source 226 provides a reference current (I3). The fifth transistor 206 may be implemented using a MISFET (e.g. a MOSFET). Any suitable kind of MISFET may be chosen (e.g. enhancement/depletion mode transistors may used). Typically, the fifth transistor 206 is the same type (i.e. p-type or n-type) as the first transistor 128.

The fifth transistor 206 may have a gate that is coupled to a node located between the first switch 228 and the gate of the first transistor 128. The fifth transistor 206 may also have a first current terminal (the source in this example) coupled to a node located between the first transistor 128 and a power supply output of the near field communications integrated circuit 14. In the present example, the power supply output of the near field communications integrated circuit 14 is represented in Figures 3 and 4 as SIMVCC 116. The fifth transistor 206 may also have a second current terminal (the drain in this example) coupled to the third current source 226. In accordance with embodiments of this disclosure, and as will be described below, the current control circuit 130 may be operable to produce first control signal 240 and the second control signal 230 dependent upon a current at the second current terminal of the fifth transistor 206.

The current control circuit 130 may further include a sixth transistor 212 and a seventh transistor 220. The sixth transistor 212 and the seventh transistor 220 form a current mirror. As shown in Figures 3 and 4, to implement the current mirror:
- the gates of the sixth transistor 212 and the seventh transistor 220 may be connected together;
- a first current terminal (the source, in this example) of the each transistor 212, 220 is connected to a reference potential (e.g. ground); and
- the gates of the sixth transistor 212 and the seventh transistor 220 are also connected to a second current terminal (the drain in this example) of the sixth transistor 212.
The second current terminal of the sixth transistor 212 accordingly forms an input (CHECK) of the current mirror, and an output (COMP _OUT) of the current mirror is formed by a second current terminal (the drain in this example) of the seventh transistor 220.

The input of the current mirror is coupled to a node located between the second current terminal of the firth transistor 206 and the third current source 226. The input of the current mirror measures a difference between the current at the second current terminal of the firth transistor 206 and the reference current provided by third current source 226. The current at the output of the current mirror is governed by this difference.

The output of the current mirror may be coupled to the power supply rail 110 via a fourth current source 227. The fourth current source 227 provides a reference current (I4).

The current control circuit is operable to use the output of the current mirror to produce the first control signal 240 and the second control signal 230. To implement this, the current control circuit 130 may further include a latch 250. The latch 250 may have an input that is coupled to the output of the current mirror. An inverter 242 may be coupled between the input of the latch 250 and the output of the current mirror. Accordingly, the output of the current mirror may be used to set/reset the latch 250.

The latch 250 may also have an output. The output of the latch 250 may be coupled to the first switch 228 via an inverter 244. This can allow the latch 250 and inverter 244 to produce the first control signal 240 and supply it to first switch 228. The output of the latch 250 may also be coupled to the second switch 214. This can allow the latch 250 to produce the second control signal 230 and supply it to second switch 214. Note that when the output of the latch 250 is low, the first control signal 240 is high, whereby the first switch 228 is closed, and second control signal 230 is low, whereby the second switch 214 is open (see Figure 3). Conversely, when the output of the latch 250 is high, the first control signal 240 is low, whereby the first switch 228 is open, and second control signal 230 is high, whereby the second switch 214 is closed (see Figure 4).

The operation of the current control circuit 130 will now be described, with reference to the circuit 200 shown in Figures 3 and 4.

As stated previously, the switching on of the first transistor 128 may be implemented in two stages. In the first stage:
- the first control signal 240 is high (due to the reference current provided by the fourth current source 227), hence the first switch 228 is closed;
- the second control signal 230 is low, hence the second switch 214 is open;
- the second current terminal of the sixth transistor 212 (and consequently the input of the current mirror) is low, due to the reference current (I3) provided by the third current source 226; and
- the output of the current mirror is low, due to the reference current (I4) provided by the fourth current source 227.

As the near field communications integrated circuit 14 begins to provide power from the power supply rail 110 to the power supply output, the current I_{load} (see Figure 3) is initially associated with loading the external capacitance CSIMCC 118 on the universal integrated circuit card supply SIMVCC 116.

In accordance with embodiments of this disclosure, I_{load} may be fixed by the first current source 222 (which provides the first reference current I1) and the ratio of the first transistor 128 to the second transistor 204. Note that the third transistor 210 and the fourth transistor 208 can ensure that the drain to source voltage V_{ds} of the first transistor 128 copies to the second transistor 204. In accordance with embodiments of this disclosure, the third transistor 210 and the fourth transistor 208 may be substantially matched, to obtain the same drain voltage on the first transistor 128 and the second transistor 204, thereby to allow a good copy of V_{ds} to be made in this way.

Initially, SIMVCC 116 is low. Accordingly, the gate to source voltage V_{gs} of the fifth transistor 206 is greater than zero. Because of this the second current terminal of the fifth transistor 206, and consequently the input to the current mirror remain low. Therefore, the first control signal 240 remains high and the second control signal 230 remains low.

As the external capacitance CSIMVCC 118 of SIMVCC 116 becomes loaded, the voltage at SIMVCC 116 will begin to rise. Consequently, the fifth transistor 206 will, at some point, begin to conduct. As the voltage at SIMVCC 116 continues to rise, the current in the fifth transistor 206 will eventually exceed the reference current (I3) provided by the third current source 226. Because of this, current will begin to flow into input of the current mirror (in this example, the sixth transistor 212 begins to conduct), which in turn will pull down the output (COMP_OUT) of the current mirror. This pulling down of the output (COMP_OUT) of the current mirror will, via the inverter 242, cause the latch 250 to be set, initiating the second stage of the switching on of the first transistor 128.

The setting of the latch 250 changes the state of the first control signal 240 (via the inverter 244) from high to low and the second control signal 230 changes state from low to high. This causes the first switch 128 to open, which decouples the gate of the first transistor 128 from the gate of the second transistor 204. This also causes the second switch 214 to close which couples the gate of the first transistor 128 to a reference voltage (e.g. ground), which causes the first transistor 128 to be fully switched on, allowing the first transistor 128 to provide a (e.g. low ohmic, compliant with the ETSI standard (1.62V @ 10ma)) path to pass current from the power supply rail 110 to SIMVCC 116.

The fifth transistor 206 may thus be used to detect desaturation in the first transistor 128. Because the gate of the fifth transistor 206 is coupled to a node located between the first switch 228 and the gate of the first transistor 128, the fifth transistor 206 and the first transistor 128 both have the same gate voltage. Accordingly, when the voltage at SIMVCC 116 rises to SIMVCC = VDDNV - Vdrop (where VDDNV is the internal low drop out (LDO) voltage and Vdrop is the voltage drop across the first transistor 128, which is defined by the on state resistance of the first transistor 128), the gate to source voltage V_{gs} of the first transistor 128 will be slightly lower than the gate to source voltage V_{gs} of the fifth transistor 206. The reference current (I3) provided by the third current source 226 may be chosen such that the second current terminal of the sixth transistor 212 and accordingly the input (CHECK) of the current mirror, goes high once this voltage condition is reached.

In accordance with embodiments of this disclosure, the first transistor 128 and the second transistor 204 may be substantially matched. This can allow a copy of the reference current I1 to be obtained, in order to limit the current I_{load} in the first stage.

In accordance with embodiments of this disclosure, the first transistor 128 and the fifth transistor 206 may be substantially matched. This can allow the fifth transistor 206 to be used accurately to detect desaturation in the first transistor 128.

Moreover, in accordance with embodiments of this disclosure, the ratio between the first transistor 128 and the second transistor 204 may be substantially the same as the ratio between the third transistor 210 and the fourth transistor 208, as well as the ratio between the reference currents (I1, I2) provided by the first current source 222 and the second current source 224.

Accordingly, there has been described a near field communications (NFC) integrated circuit and method for a mobile communications device. The integrated circuit includes a power supply rail for providing a regulated supply of power to components within the integrated circuit. The integrated circuit also includes a first transistor coupled between the power supply rail and a power supply output of the integrated circuit for selectively providing power to a universal integrated circuit card (UICC) of the mobile communications device from the power supply rail while the mobile communications device is in an off state. The integrated circuit further includes a current control circuit for controlling the operation of the first transistor to prevent a drop in voltage on the power supply rail as the first transistor is switched to an on state to couple the power supply rail to the power supply output.

Although particular embodiments of this disclosure have been described, it will be appreciated that many modifications/additions and/or substitutions may be made within the scope of the claims.

## Claims

1. A near field communications (NFC) integrated circuit (14) for a mobile communications device, the integrated circuit comprising:
a power supply rail (110) for providing a regulated supply of power to components within the integrated circuit;
a first transistor (128) coupled between the power supply rail and a power supply output (116) of the integrated circuit for selectively providing power to a universal integrated circuit card (UICC) of the mobile communications device from the power supply rail while the mobile communications device is in an off state; and
a current control circuit (130) for controlling the operation of the first transistor to prevent a drop in voltage on the power supply rail as the first transistor is switched to an on state to couple the power supply rail to the power supply output,
**characterised in that** the current control circuit comprises:
a first switch (228);
a second switch (214), wherein a gate of the first transistor is coupleable to reference potential via the second switch;
a second transistor (204) having a gate coupleable to the gate of the first transistor via the first switch, and
a third transistor (210) and a fourth transistor (208), wherein a gate of the third transistor is coupled to a gate of the fourth transistor,
wherein the second transistor and the fourth transistor are coupled in series between the power supply rail and a first current source (222), the second transistor being coupled to the power supply rail and the fourth transistor being coupled to the first current source,
wherein the first transistor and the third transistor are coupled in series between the power supply rail and a second current source (224), the first transistor being coupled to the power supply rail and the third transistor being coupled to the second current source,
wherein a node located between the fourth transistor and the first current source is coupled to a node located between the gate of the second transistor and the first switch, and
wherein a node located between the third transistor and the second current source is coupled to the gates of the third transistor and fourth transistor.

2. The integrated circuit of claim 1, wherein the current control circuit is operable in an initial step for switching the first transistor to the on state to close the first switch and to open the second switch, whereby current flow from the power supply rail to the power supply output is governed by a ratio of currents flowing through the first transistor and the second transistor.

3. The integrated circuit of claim 2, wherein the current control circuit is operable in a next step for switching the first transistor to the on state to open the first switch and to close the second switch, whereby the first transistor is fully switched to said on state to provide power from the power supply rail to the power supply output.

4. The integrated circuit of any preceding claim, wherein the current control circuit further comprises a fifth transistor coupled in series with the first transistor and a third current source, the fifth transistor having:
a gate coupled to a node located between the first switch and the gate of the first transistor;
a first current terminal coupled to a node located between the first transistor and the power supply output; and
a second current terminal coupled to said third current source,
wherein the current control circuit is operable to produce control signals for operating the first switch and the second switch dependent upon a current at said second current terminal.

5. The integrated circuit of claim 4, wherein the current control circuit further comprises a sixth transistor and a seventh transistor forming a current mirror, wherein:
an input of the current mirror is coupled to a node located between the second current terminal of the firth transistor and the third current source;
and wherein the current control circuit is operable to use an output of the current mirror to produce said control signals.

6. The integrated circuit of claim 5, wherein the current control circuit further comprises a latch having:
an input coupled to the output of the current mirror; and
an output coupled to:
the first switch via an inverter, for providing a first said control signal to the second switch; and
the second switch for providing a second said control signal to the second switch.

7. The integrated circuit of any of claims 4 to 6, wherein the first and fifth transistors are substantially matched.

8. The integrated circuit of any preceding claim, wherein the first and second transistors are substantially matched.

9. The integrated circuit of any preceding claim, wherein the third and fourth transistors are substantially matched.

10. A mobile communications device including the near field communications (NFC) integrated circuit of any preceding claim.

11. The mobile communications device of claim 10, further comprising said universal integrated circuit card (UICC).

12. The mobile communications device of claim 11, wherein the mobile communications device is operable to provide power to the universal integrated circuit card without providing power to the universal integrated circuit card from the near field communications (NFC) integrated circuit when the mobile communications device is in an on state.

## Patentansprüche

1. Integrierte Nahfeldkommunikationsschaltung (NFC-Schaltung) (14) für eine Mobilkommunikationsvorrichtung, wobei die integrierte Schaltung Folgendes umfasst:
eine Stromversorgungsschiene (110) zum Bereitstellen einer gesteuerten Zufuhr von Strom zu Komponenten in der integrierten Schaltung;
einen ersten Transistor (128), der zwischen die Stromversorgungsschiene und einen Stromversorgungsausgang (116) der integrierten Schaltung gekoppelt ist, um von der Stromversorgungsschiene wahlweise Leistung zu einer universellen Karte (UICC) mit integrierter Schaltung der Mobilkommunikationsvorrichtung zu liefern, während die Mobilkommunikationsvorrichtung in einem Aus-Zustand ist; und
eine Stromsteuerschaltung (130) zum Steuern des Betriebs des ersten Transistors, um einen Spannungsabfall an der Stromversorgungsschiene zu verhindern, wenn der erste Transistor zu einem Ein-Zustand geschaltet wird, um die Stromversorgungsschiene an die Stromversorgungsausgang zu koppeln, wobei
die Stromsteuerschaltung **gekennzeichnet ist durch**:
einen ersten Schalter (228);
einen zweiten Schalter (214), wobei ein Gate des ersten Transistors mittels des zweiten Schalters an das Bezugspotential koppelbar ist;
einen zweiten Transistor (204), der ein Gate besitzt, das mittels des ersten Schalters an das Gate des ersten Transistors koppelbar ist, und
einen dritten Transistor (210) und einen vierten Transistor (208), wobei ein Gate des dritten Transistors an ein Gate des vierten Transistors gekoppelt ist, wobei
der zweite Transistor und der vierte Transistor zwischen der Stromversorgungsschiene und einer ersten Stromquelle (222) in Reihe geschaltet sind, wobei der zweite Transistor an die Stromversorgungsschiene gekoppelt ist und der vierte Transistor an die erste Stromquelle gekoppelt ist,
der erste Transistor und der dritte Transistor zwischen der Stromversorgungsschiene und einer zweiten Stromquelle (224) in Reihe geschaltet sind, wobei der erste Transistor an die Stromversorgungsschiene gekoppelt ist und der dritte Transistor an die zweite Stromquelle gekoppelt ist,
ein Knoten, der zwischen dem vierten Transistor und der ersten Stromquelle angeordnet ist, an einen Knoten gekoppelt ist, der zwischen dem Gate des zweiten Transistors und dem ersten Schalter angeordnet ist, und
ein Knoten, der zwischen dem dritten Transistor und der zweiten Stromquelle angeordnet ist, an die Gates des dritten Transistors und des vierten Transistors gekoppelt ist.

2. Integrierte Schaltung nach Anspruch 1, wobei die Stromsteuerschaltung in einem anfänglichen Schritt zum Schalten des ersten Transistors zum Ein-Zustand betreibbar ist, den ersten Schalter zu schließen und den zweiten Schalter zu öffnen, wodurch Stromfluss von der Stromversorgungsschiene zum Stromversorgungsausgang durch ein Verhältnis von Strömen, die durch den ersten Transistor und den zweiten Transistor fließen, gesteuert wird.

3. Integrierte Schaltung nach Anspruch 2, wobei die Stromsteuerschaltung in einem nächsten Schritt zum Schalten des ersten Transistors zum Ein-Zustand betreibbar ist, den ersten Schalter zu öffnen und den zweiten Schalter zu schließen, wodurch der erste Transistor vollständig zum Ein-Zustand geschaltet wird, um Leistung von der Stromversorgungsschiene zum Stromversorgungsausgang zu liefern.

4. Integrierte Schaltung nach einem vorhergehenden Anspruch, wobei die Stromsteuerschaltung ferner einen fünften Transistor umfasst, der mit dem ersten Transistor und einer dritten Stromquelle in Reihe geschaltet ist, und der fünfte Transistor Folgendes aufweist:
ein Gate, das an einen Knoten gekoppelt ist, der zwischen dem ersten Schalter und dem Gate des ersten Transistors angeordnet ist;
einen ersten Stromanschluss, der an einen Knoten gekoppelt ist, der zwischen dem ersten Transistor und dem Stromversorgungsausgang angeordnet ist; und
einen zweiten Stromanschluss, der an die dritte Stromquelle gekoppelt ist, wobei die Stromsteuerschaltung betreibbar ist, Steuersignale zum Betätigen des ersten Schalters und des zweiten Schalters abhängig von einem Strom am zweiten Stromanschluss zu erzeugen.

5. Integrierte Schaltung nach Anspruch 4, wobei die Stromsteuerschaltung ferner einen sechsten Transistor und einen siebten Transistor umfasst, die einen Stromspiegel bilden, wobei
ein Eingang des Stromspiegels an einen Knoten gekoppelt ist, der zwischen dem zweiten Stromanschluss des fünften Transistors und der dritten Stromquelle angeordnet ist; und
die Stromsteuerschaltung betreibbar ist, einen Ausgang des Stromspiegels zu verwenden, um die Steuersignale zu erzeugen.

6. Integrierte Schaltung nach Anspruch 5, wobei die Stromsteuerschaltung ferner eine Speicherschaltung umfasst, die Folgendes aufweist:
einen Eingang, der an den Ausgang des Stromspiegels gekoppelt ist; und
einen Ausgang, der an Folgendes gekoppelt ist:
den ersten Schalter mittels eines Wechselrichters, um ein erstes Steuersignal zum zweiten Schalter zu liefern; und
den zweiten Schalter, um ein zweites Steuersignal zum zweiten Schalter zu liefern.

7. Integrierte Schaltung nach einem der Ansprüche 4 bis 6, wobei der erste und der fünfte Transistor im Wesentlichen abgestimmt sind.

8. Integrierte Schaltung nach einem vorhergehenden Anspruch, wobei der erste und der zweite Transistor im Wesentlichen abgestimmt sind.

9. Integrierte Schaltung nach einem vorhergehenden Anspruch, wobei der dritte und der vierte Transistor im Wesentlichen abgestimmt sind.

10. Mobilkommunikationsvorrichtung, die die integrierte Nahfeldkommunikationsschaltung (NFC-Schaltung) nach einem vorhergehenden Anspruch enthält.

11. Mobilkommunikationsvorrichtung nach Anspruch 10, die ferner die universelle Karte (UICC) mit integrierter Schaltung umfasst.

12. Mobilkommunikationsvorrichtung nach Anspruch 11, wobei die Mobilkommunikationsvorrichtung betreibbar ist, Leistung zur universellen Karte mit integrierter Schaltung zu liefern, ohne Leistung von der integrierten Nahfeldkommunikationsschaltung (NFC-Schaltung) zur universellen Karte mit integrierter Schaltung zu liefern, wenn die Mobilkommunikationsvorrichtung in einem Ein-Zustand ist.

## Revendications

1. Circuit intégré de communication en champ proche (NFC) (14) pour un dispositif de communication mobile, le circuit intégré comprenant :
un rail d'alimentation électrique (110) pour assurer une alimentation électrique régulée sur des composants à l'intérieur du circuit intégré ;
un premier transistor (128) couplé entre le rail d'alimentation électrique et une sortie d'alimentation électrique (116) du circuit intégré pour fournir sélectivement de l'énergie électrique à une carte à circuit intégré universelle (UICC) du dispositif de communication mobile depuis le rail d'alimentation électrique tandis que le dispositif de communication mobile est dans un état désactivé ; et
un circuit de commande de courant (130) pour commander le fonctionnement du premier transistor pour empêcher une chute de la tension sur le rail d'alimentation électrique lorsque le premier transistor est commuté dans un état activé pour coupler le rail d'alimentation électrique sur la sortie d'alimentation électrique,
**caractérisé en ce que** le circuit de commande de courant comprend :
un premier commutateur (228) ;
un second commutateur (214), dans lequel une grille du premier transistor peut être couplée à un potentiel de référence via le second commutateur ;
un deuxième transistor (204) comportant une grille pouvant être couplée à la grille du premier transistor via le premier commutateur, et
un troisième transistor (210) et un quatrième transistor (208), dans lequel une grille du troisième transistor est couplée à une grille du quatrième transistor,
dans lequel le deuxième transistor et le quatrième transistor sont couplés en série entre le rail d'alimentation électrique et une première source de courant (222), le deuxième transistor étant couplé au rail d'alimentation électrique et le quatrième transistor étant couplé à la première source de courant,
dans lequel le premier transistor et le troisième transistor sont couplés en série entre le rail d'alimentation électrique et une deuxième source de courant (224), le premier transistor étant couplé au rail d'alimentation électrique et le troisième transistor étant couplé à la deuxième source de courant,
dans lequel un noeud localisé entre le quatrième transistor et la première source de courant est couplé à un noeud localisé entre la grille du deuxième transistor et le premier commutateur, et
dans lequel un noeud localisé entre le troisième transistor et la deuxième source de courant est couplé aux grilles du troisième transistor et du quatrième transistor.

2. Circuit intégré selon la revendication 1, dans lequel le circuit de commande de courant peut être rendu opérationnel au niveau d'une étape initiale pour commuter le premier transistor dans l'état activé pour fermer le premier commutateur et pour ouvrir le second commutateur, d'où il résulte qu'une circulation de courant depuis le rail d'alimentation électrique jusqu'à la sortie d'alimentation électrique est gouvernée par un rapport de courants circulant au travers du premier transistor et du deuxième transistor.

3. Circuit intégré selon la revendication 2, dans lequel le circuit de commande de courant peut être rendu opérationnel au niveau d'une étape suivante pour commuter le premier transistor dans l'état activé pour ouvrir le premier commutateur et pour fermer le deuxième commutateur, d'où il résulte que le premier transistor est complètement commuté dans ledit état activé pour fournir de l'énergie électrique depuis le rail d'alimentation électrique sur la sortie d'alimentation électrique.

4. Circuit intégré selon l'une quelconque des revendications précédentes, dans lequel le circuit de commande de courant comprend en outre un cinquième transistor couplé en série avec le premier transistor et une troisième source de courant, le cinquième transistor comportant :
une grille couplée à un noeud localisé entre le premier commutateur et la grille du premier transistor ;
une première borne de courant couplée à un noeud localisé entre le premier transistor et la sortie d'alimentation électrique ; et
une seconde borne de courant couplée à ladite troisième source de courant,
dans lequel le circuit de commande de courant peut être rendu opérationnel pour produire des signaux de commande pour le fonctionnement du premier commutateur et du second commutateur en fonction d'un courant au niveau de ladite seconde borne de courant.

5. Circuit intégré selon la revendication 4, dans lequel le circuit de commande de courant comprend en outre un sixième transistor et un septième transistor formant un miroir de courant, dans lequel :
une entrée du miroir de courant est couplée à un noeud localisé entre la seconde borne de courant du cinquième transistor et la troisième source de courant ; et
dans lequel le circuit de commande de courant peut être rendu opérationnel pour utiliser une sortie du miroir de courant pour produire lesdits signaux de commande.

6. Circuit intégré selon la revendication 5, dans lequel le circuit de commande de courant comprend en outre un moyen de verrouillage comportant :
une entrée couplée sur la sortie du miroir de courant ; et
une sortie couplée sur :
le premier commutateur via un inverseur, pour appliquer un premier dit signal de commande sur le second commutateur ; et
le second commutateur pour appliquer un second dit signal de commande sur le second commutateur.

7. Circuit intégré selon l'une quelconque des revendications 4 à 6, dans lequel les premier et cinquième transistors sont sensiblement en adaptation.

8. Circuit intégré selon l'une quelconque des revendications précédentes, dans lequel les premier et deuxième transistors sont sensiblement en adaptation.

9. Circuit intégré selon l'une quelconque des revendications précédentes, dans lequel les troisième et quatrième transistors sont sensiblement en adaptation.

10. Dispositif de communication mobile incluant le circuit intégré de communication en champ proche (NFC) selon l'une quelconque des revendications précédentes.

11. Dispositif de communication mobile selon la revendication 10, comprenant en outre ladite carte à circuit intégré universelle (UICC).

12. Dispositif de communication mobile selon la revendication 11, dans lequel le dispositif de communication mobile peut être rendu opérationnel pour fournir de l'énergie électrique à la carte à circuit intégré universelle sans fournir de l'énergie électrique à la carte à circuit intégré universelle depuis le circuit intégré de communication en champ proche (NFC) lorsque le dispositif de communication mobile est dans un état activé.
